(19) Europäisches Patentamt
European Patent Office
Office européen des brevets

(11) **EP 2 655 705 B1**

(12) **EUROPEAN PATENT SPECIFICATION**

(45) Date of publication and mention
of the grant of the patent:
**28.01.2015 Bulletin 2015/05**

(21) Application number: **11807894.8**

(22) Date of filing: **19.12.2011**

(51) Int Cl.:
***C30B 35/00*** *(2006.01)*       ***C04B 35/591*** *(2006.01)*
***F27B 14/10*** *(2006.01)*

(86) International application number:
**PCT/EP2011/073250**

(87) International publication number:
**WO 2012/084832 (28.06.2012 Gazette 2012/26)**

(54) **CRUCIBLES**

TIEGEL

CREUSETS

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **22.12.2010 EP 10196529**

(43) Date of publication of application:
**30.10.2013 Bulletin 2013/44**

(73) Proprietor: **Steuler Solar GmbH
56203 Höhr-Grenzhausen (DE)**

(72) Inventor: **ROLIGHETEN, Rune
N-3919 Porsgrunn (NO)**

(74) Representative: **Von Kreisler Selting Werner -
Partnerschaft
von Patentanwälten und Rechtsanwälten mbB
Deichmannhaus am Dom
Bahnhofsvorplatz 1
50667 Köln (DE)**

(56) References cited:
**EP-A2- 0 268 166        CH-A- 326 155
GB-A- 895 769        GB-A- 1 373 816
US-A- 3 206 318        US-A- 5 928 601**

**Description**

The invention relates to a method for manufacturing crucibles for the production of ingots of silicon and the crucible.

Silicon is an element of diverse industrial use.

One use is in photovoltaic applications. For the photovoltaic industry, ultrapure silicon is needed.

Due to concerns related to climate change and energy supply, photovoltaic solar energy is experiencing large industrial developments. To be competitive against traditional energy sources, it is vital that the cost of solar energy is reduced.

For the production of solar cells, polycrystalline and monocrystalline silicium is used. Crystallization of silicon or silicium is typically conducted by crystallization in crucibles. This method is based on the effect that ingots can be produced from melted silicon which is slowly cooled down. It is a method of directional solidification. It produces ingots which are cut into smaller blocks and further to wafers.

To maintain purity of the silicon, the crucible must be highly inert and allow control of a temperature gradient during the solidification. Because the crucible is in direct contact with a molded silicon, it may be a source of contamination. The crucible should be chemically inert and withstand high temperatures of up to 1500°C for relatively long periods.

The typical commercially available materials are crucibles made of quartz ($SiO_2$). During phase transformation upon cooling, the quartz material typically cracks. Therefore, the quartz crucibles are for one time use only. Impurities from the quartz material might diffuse into the wafer material, which reduces the electrical performance of solar cells.

It has been tried to introduce other materials, especially silicon nitride ($Si_3N_4$) as a material for crucibles.

WO 2007/148986 describes a crucible made of so-called "nitride bonded silicon nitride". According to this document, a material formed from a slurry of more than 60% by weight of silicon nitride particles and less than 40% by weight silicon particles are formed into a crucible and heated in a nitrogen atmosphere.

WO 2004/016835 discloses a method for the production of crucibles by dry-pressing of silicon particles, followed by conversion to silicon nitride.

EP 0 268 166 discloses a material for the production of for example crucibles comprising silicon, nitrogen and oxygen.

Beside these attempts, it has not yet been successful to produce crucibles of silicon nitride which are re-usable and allow production of ingots of high quality.

It is the object of the present invention to provide crucibles which overcome at least some of the drawbacks of prior art, especially the production of re-usable crucibles and/or crucibles which allow production of silicon ingots having improved properties.

This object is solved by the method of the present invention. The method of the present invention is a method for manufacturing a crucible comprising the steps of

- preparing a slurry of solids and liquids, said solids consisting of
- silicon metal powder
- up to 25% (w/w) SiC powder
- up to 10% (w/w) SiN
- up to 0,5% (w/w) of a catalyst
- up to 1% (w/w) of a binder
- forming the slurry into a green body of a crucible
- heating the green body in a nitrogen atmosphere, optionally comprising inert gas, to react the silicon at least partially to silicon nitride.

According to the present invention, in a first step a slurry is prepared. The slurry comprises solids and liquids. From the solids in the material at least 63.5% by weight are silicon metal powder (particles). From a mixture of solids and liquids, the solids can be recovered by heating the mixture in an open arrangement at normal pressure to a temperature of 250°C for 24 h. From these thus obtained solids at least 63.5% by weight are silicon metal powder.

Silicon metal powder according to the invention is a silver grey or dark grey powder with metallic luster. It can be purchased from a number of companies in different particle sizes. A powder according to the invention is a material having a particle size of up to 500 $\mu$m.

In some embodiments, it is useful to use particle sizes of less than 100 $\mu$m or less than 45 $\mu$m. It is also possible to use different particle sizes of the silicon powder or other ingredients together.

According to the invention, the silicon metal powder is combined with a liquid. A preferred liquid is water, but organic solvents or mixtures of organic solvents with water may be used as well.

Particles are typically offered in particle size ranges, for example 0 to 100 $\mu$m or 0 to 45 $\mu$m. In these cases, the particles have a particle size of 100 $\mu$m or less or 45 $\mu$m or less, respectively.

In one embodiment, the particle size is determined on the basis of median particle size. In this case, a particle size distribution is analyzed in accordance with ISO 9276-5.

The mass median particle size divides the particles in two halfs: 50% of the mass of the particles is larger; 50% of the mass the particles is smaller. This is also designated as d50.

In this case, the mean mass particle size diameter should preferably be between 15 and 75 $\mu$m.

In a further embodiment, the particle size range with the highest occurrence is used to characterize a particle size distribution. This is also designated as "mode". A mode particle size of 15 to 75 $\mu$m is preferred.

By mixing at least two different particle size distributions, the overall particle size distribution becomes at least bimodal. This is especially preferred. In a bimodal mixture, there are two particle diameters that occur with a higher frequency than the neighboring particle sizes.

In some embodiments, the slurry which is formed to green body comprises additionally SiC powder. If SiC powder is present it is present in an amount of at least 1%, preferably at least 5% by weight of the solids. In some embodiments, the amount of SiC powder is up to 10% or up to 20% or up to 25% by weight of the solids.

The presence of SiC further increases thermal conductivity.

In some embodiments, the mixture further comprises a catalyst. An amount of about up to 0.5% by weight of the solids has been found sufficient. One preferred catalyst is FeO.

In other embodiments, the material comprises a binder. A binder may help to stabilize the green body. An amount of the binder of 1.0% by weight of the mixture is typically sufficient. Suitable binders are for example aqueous polymer dispersions.

Any organic materials are burned off the material during the early phase of firing and are not present in the final crucible.

It is possible that the material for forming the green body also comprises silicon nitride. It is preferred that no silicon nitride is used for the production of the green body. The amount of silicon nitride should not exceed 10% by weight of the solid materials, preferably not exceed 5% and even more preferred not exceed 1% in the solid material.

For mixing the material, it is possible to use a ball mill. Silicon nitride balls can be used as a grinding media.

This material is used for forming a green body of a crucible for crystallization of silicon. A crucible is a container which is able to withstand high temperature (above 1000°C). It has a cup shape with one large opening. It may have a number of different shapes including circular, rectangular and the like. Embodiments of forming the green body are slip casting, pressure casting, freeze casting, gel casting and the like.

A "green body" as used herein is a shaped object prepared from the slurry. It comprises solids, a liquid and optionally organic materials and is ductile.

In one embodiment, the slurry is formed into a crucible by using a mould. A mould having the exterior proportion of the crucible is filled with the material of the invention and the inner surface is formed by pressing a plunger into the material.

In other embodiments, it is possible to form pieces of a crucible by producing flat elements. These elements may be formed or cut into shapes. This allows the combination of several elements to the walls and bottom of a crucible. To assure tightness of the crucible, it is possible to fill edges of such an assembled green body with further material from the slurry.

In one preferred embodiment, the slurry is allowed to dry for a short time at room temperature after shaping. This stabilizes the green body. In the next step, the green body is heated in a nitrogen atmosphere. Heating can be conducted for example in a kiln. The temperature of the kiln is slowly increased. Heating is conducted in an atmosphere comprising nitrogen, optionally together with inert gas. Typical inert gas is argon or helium. When the temperature of the kiln reaches about 1000°C, the conversion of the silicium metal into silicon nitride begins. Depending on the type of kiln this can be observed by a pressure drop in the kiln.

In preferred embodiments, the temperature of the heating step is increased at least to about 1050°C, preferably above 1250°C, and more preferably above 1400°C.

Depending on the thickness of the crucible walls, conversion of the silicon metal to silicon nitrate needs sufficient time. Typically conversion is conducted within several days.

In preferred embodiments, the heating is conducted for a time of at least 3 days at a temperature above 1000°C. Typically, heating for up to 10 days at temperatures above 1000°C is sufficient. Because the conversion of silicon to silicon nitride is exothermic, it is important to control temperature and pressure of the nitrogen to avoid overheating of the product which might result in out melting of silicon.

To achieve conversion to silicon nitride, it is important to maintain a nitrogen atmosphere during the heating step. Typically, the pressure of the atmosphere including nitrogen and optionally inert gas is between 200 and 1400 mbar. Preferably the partial pressure of nitrogen is at least 100 mbar during the heating step.

Surprisingly, the crucible obtained by the method of the present invention has superior properties. Compared to other crucible it has a very low porosity in the range of 14 to 25% (measured as apparent porosity according to ASTM C-20). This clearly distinguishes from WO 2004/016835 which discloses porosities of 40 to 60%.

It also has a high density in the range of 2.3 to 2.6 kg/l, which is higher than for silicon nitride crucibles of prior art. Preferably, the density is 2.4 kg/l <u>or</u> more, 2.45 kg/l or more or 2.5 kg/l or more.

WO 2004/016835 A1 discloses crucibles having a density of only 1.85 kg/l.

It has been seen that using the crucibles of the present invention, it is possible to produce ingots of superior quality. The thermal shock resistance of a material can be estimated in accordance to the following formula

$$Rs = (\lambda * \sigma f)/(a*E)$$

where
Rs = Thermal shock resistance
$\lambda$ = Thermal conductivity

σf = Flexural strength
a = Coefficient of thermal expansion
E = Modulus of elasticity

Because the crucibles have a higher flexural strength and a higher thermal conductivity, the crucibles of the present invention have an improved lifetime and can be re-used several times.

A further embodiment of the invention is a method for manufacturing a crucible comprising the steps of

- preparing a slurry of solids and liquids, wherein at least 60% (w/w) of the solids are silicon metal powder
- forming the slurry into a green body of a crucible
- heating the green body in a nitrogen atmosphere, optionally comprising inert gas, to react the silicon at least partially to silicon nitride.

According to the invention, the final product comprises no organic material and essentially no inorganic oxygen containing material i.e. it is free from ingredients like $SiO_2$ $Al_2O_3$ and the like. Oxygen may be present in the slurry from liquids or organic materials like binders. In the crucible, no or only very small amounts (< 0.5% (w/w)) of oxygen containing inorganic compounds are present.

The invention is explained in more details by the following, non-limiting examples.

### Example 1

A mixture is prepared from silicon powder having a particles size below 10 $\mu$m and a particle size below 45 $\mu$m (1:1 by weight) together with about 25% of weight of the solids of water together with a binder of aqueous polymer dispersion.

Plate elements are formed from the mixture and allowed to dry at room temperature for about 24 h. Necessary dimensions are cut by a water jet cutter to form elements for side walls and bottoms of the crucible. The elements are fixed together by using the slurry of the example. The green body is heated to about 600°C for 6 hours and then the temperature is slowly increased to about 1050°C until pressure in the kiln drops. A nitrogen atmosphere of about 500 mbar is used during the firing. The temperature is slowly increased during further heating to 1250°C and, finally, up to 1400°C over the next 4 days. The crucible is then kept at a temperature of 1400°C for the remaining 24 hours. During this time, partial pressure of nitrogen can be slowly increased to achieve an controlled reaction rate.

### Example 2

Silicon metal powder of a particle size below 45 $\mu$m is mixed with 20% by weight of a SiC powder of a particle size below 100 $\mu$m and a particle size below 10 $\mu$m (1:3 by weight). 25% (by weight of solids) of water is added and the mixture is filled into a mould which is the outer surface of the crucible. The inner surface is formed by pressing a plunger into the material. After drying for 30 minutes at room temperature, the green body can be removed from the mould and the plunger and fired according to the conditions of example 1.

## Claims

1. A method for manufacturing a crucible for the crystallization of silicon comprising the steps of

   • preparing a slurry of solids and liquids, said solids consisting of

      • silicon metal powder
      • up to 25% (w/w) SiC powder
      • up to 10% (w/w) SiN
      • up to 0,5% (w/w) of a catalyst
      • up to 1% (w/w) of a binder

   • forming the slurry into a green body of a crucible
   • heating the green body in a nitrogen atmosphere, optionally comprising inert gas, to react the silicon at least partially to silicon nitride.

2. The method of claim 1, wherein the particle size of the silicon metal powder is in the range of 0 to 100 $\mu$m, preferably 0 to 45 $\mu$m.

3. The method of claim 1 or 2, wherein at least 75% (w/w) of the solids are silicon metal powder.

4. The method of any one of claims 1 to 3, wherein the solids comprise up to 15% (w/w) SiC powder.

5. The method of any one of claims 1 to 4, wherein the catalyst is FeO and/or the binder is an aqueous polymer dispersion.

6. The method of any one of claims 1 to 5, wherein the inert gas is selected from argon, helium and mixtures thereof.

7. The method of any one of claims 1 to 6, wherein the pressure of the nitrogen, optionally including inert gas, atmosphere is between 200 and 1400 mbar.

8. The method of any one of claims 1 to 7, wherein heating is conducted at temperatures above 1050°C, preferably above 1250°C, more preferably above 1400°C.

9. The method of any one of claims 1 to 8, wherein heating is conducted for 3 to 14 days at temperatures above 1000°C.

10. The method of any of claims 1 to 9, wherein the silicon metal powder is in a bimodal or multimodal particle size distribution.

**11.** A crucible obtainable by the method of any of claims 1 to 10.

**12.** The crucible of claim 11 having an apparent porosity of 14 to 25%, measured according to ASTM C-20.

**13.** The crucible of claim 11 or 12 having a density of 2.3 to 2.6 kg/dm$^3$.

**14.** Use of the crucible of any of claims 10 to 13 for the crystallization of silicon.

**15.** Use according to claim 14, wherein the silicon is monocrystalline.

**16.** Use according to claim 14, wherein the silicon is polycrystalline.


**Patentansprüche**

**1.** Verfahren zur Herstellung eines Tiegels zur Kristallisation von Silicium, umfassend die Schritte

> • Herstellen einer Aufschlämmung von Feststoffen und Flüssigkeiten, wobei die Feststoffe aus
>
> > • Siliciummetallpulver
> > • bis zu 25 Gew.-% SiC-Pulver
> > • bis zu 10 Gew.-% SiN
> > • bis zu 0,5 Gew.-% eines Katalysators
> > • bis zu 1 Gew.-% eines Bindemittels
>
> bestehen;
> • Verarbeiten der Aufschlämmung zu einem Grünkörper eines Tiegels;
> • Erhitzen des Grünkörpers in einer Stickstoffatmosphäre, die gegebenenfalls Inertgas umfasst, wobei das Silicium wenigstens teilweise zu Siliciumnitrid umgesetzt wird.

**2.** Verfahren gemäß Anspruch 1, wobei die Teilchengröße des Siliciummetallpulvers im Bereich von 0 bis 100 $\mu$m, vorzugsweise 0 bis 45 $\mu$m, liegt.

**3.** Verfahren gemäß Anspruch 1 oder 2, wobei es sich bei wenigstens 75 Gew.-% der Feststoffe um Siliciummetallpulver handelt.

**4.** Verfahren gemäß einem der Ansprüche 1 bis 3, wobei die Feststoffe bis zu 15 Gew.-% SiC-Pulver umfassen.

**5.** Verfahren gemäß einem der Ansprüche 1 bis 4, wobei es sich bei dem Katalysator um FeO und/oder bei dem Bindemittel um eine wässrige Polymerdispersion handelt.

**6.** Verfahren gemäß einem der Ansprüche 1 bis 5, wobei das Inertgas aus Argon, Helium und Gemischen davon ausgewählt ist.

**7.** Verfahren gemäß einem der Ansprüche 1 bis 6, wobei der Druck der Stickstoffatmosphäre, die gegebenenfalls Inertgas umfasst, zwischen 200 und 1400 mbar liegt.

**8.** Verfahren gemäß einem der Ansprüche 1 bis 7, wobei das Erhitzen bei Temperaturen von über 1050 °C, vorzugsweise über 1250 °C, besonders bevorzugt über 1400 °C, durchgeführt wird.

**9.** Verfahren gemäß einem der Ansprüche 1 bis 8, wobei das Erhitzen 3 bis 14 Tage lang bei Temperaturen von über 1000 °C durchgeführt wird.

**10.** Verfahren gemäß einem der Ansprüche 1 bis 9, wobei das Siliciummetallpulver in einer bimodalen oder multimodalen Teilchengrößenverteilung vorliegt.

**11.** Tiegel, erhältlich nach dem Verfahren gemäß einem der Ansprüche 1 bis 10.

**12.** Tiegel gemäß Anspruch 11, der eine scheinbare Porosität von 14 bis 25%, gemessen gemäß ASTM C-20, aufweist.

**13.** Tiegel gemäß Anspruch 11 oder 12, der eine Dichte von 2,3 bis 2,6 kg/dm$^3$ aufweist.

**14.** Verwendung des Tiegels gemäß einem der Ansprüche 10 bis 13 zur Kristallisation von Silicium.

**15.** Verwendung gemäß Anspruch 14, wobei das Silicium monokristallin ist.

**16.** Verwendung gemäß Anspruch 14, wobei das Silicium polykristallin ist.


**Revendications**

**1.** Procédé de fabrication d'un creuset destiné à la cristallisation du silicium comprenant les étapes:

> - préparation d'une suspension épaisse de solides et de liquides, lesdits solides comprenant :
>
> > - une poudre de silicium métallique
> > - jusqu'à 25% (p/p) d'une poudre de SiC
> > - jusqu'à 10% (p/p) de SiN
> > - jusqu'à 0,5% (p/p) d'un catalyseur
> > - jusqu'à 1% (p/p) d'un liant

- mise en forme de la suspension épaisse en un corps vert de creuset

- chauffage du corps vert dans une atmosphère d'azote, comportant facultativement un gaz inerte, afin de convertir le silicium, au moins partiellement, en nitrure de silicium.

2. Procédé selon la revendication 1, dans lequel le diamètre de particule de la poudre de silicium métallique est compris dans la plage de 0 à 100 $\mu$m, de préférence de 0 à 45 $\mu$m.

3. Procédé selon la revendication 1 ou 2, dans lequel 75% (p/p) au moins des solides sont de la poudre de silicium métallique.

4. Procédé selon l'une quelconque des revendications 1 à 3, dans lequel les solides comportent jusqu'à 15% (p/p) de poudre de SiC.

5. Procédé selon l'une quelconque des revendications 1 à 4, dans lequel le catalyseur est FeO et/ou dans lequel le liant est une dispersion aqueuse de polymère.

6. Procédé selon l'une quelconque des revendications 1 à 5, dans lequel le gaz inerte est sélectionné parmi l'argon, de l'hélium et leurs mélanges.

7. Procédé selon l'une quelconque des revendications 1 à 6, dans lequel la pression de l'atmosphère d'azote, incluant facultativement un gaz inerte, est comprise entre 200 et 1400 mbars.

8. Procédé selon l'une quelconque des revendications 1 à 7, dans lequel le chauffage est réalisé à des températures supérieures à 1050°C, de préférence supérieures à 1250°C, avec plus de préférence supérieures à 1400°C.

9. Procédé selon l'une quelconque des revendications 1 à 8, dans lequel le chauffage est effectué pendant 3 à 14 jours à des températures supérieures à 1000°C.

10. Procédé selon l'une quelconque des revendications 1 à 9, dans lequel la poudre de silicium métallique présente une distribution granulométrique bimodale ou multimodale.

11. Creuset pouvant être obtenu par le procédé selon l'une quelconque des revendications 1 à 10.

12. Creuset selon la revendication 11 présentant une porosité apparente de 14 à 25%, mesurée selon la norme ASTM C-20.

13. Creuset selon la revendication 11 ou 12 présentant une densité de 2,3 à 2,6 kg/dm$^3$.

14. Utilisation du creuset selon l'une quelconque des revendications 10 à 13 pour la cristallisation du silicium.

15. Utilisation selon la revendication 14, dans laquelle le silicium est monocristallin.

16. Utilisation selon la revendication 14, dans laquelle le silicium est polycristallin.

**REFERENCES CITED IN THE DESCRIPTION**

**Patent documents cited in the description**

- WO 2007148986 A
- WO 2004016835 A
- EP 0268166 A
- WO 2004016835 A1